Europäisches Patentamt

European Patent Office

Office européen des brevets

(11) Numéro de publication: **0 395 109**
**A1**

## (12) DEMANDE DE BREVET EUROPEEN

(21) Numéro de dépôt: **90108118.2**

(22) Date de dépôt: **27.04.90**

(51) Int. Cl.⁵: **H03L 7/187**

(30) Priorité: **28.04.89 FR 8905698**

(43) Date de publication de la demande:
**31.10.90 Bulletin 90/44**

(84) Etats contractants désignés:
**BE DE ES FR GB IT NL SE**

(71) Demandeur: **ALCATEL TRANSMISSION PAR FAISCEAUX HERTZIENS A.T.F.H.**
**55, rue Greffulhe**
**F-92300 Levallois-Perret Cédex(FR)**
(84) **DE ES FR GB IT NL SE**

Demandeur: **ALCATEL N.V.**
**Strawinskylaan 341 (World Trade Center)**
**NL-1077 XX Amsterdam(NL)**
(84) **BE**

(72) Inventeur: **Transon, Eric**
**7, rue Henri Dunant**
**F-95300 Pontoise(FR)**

(74) Mandataire: **Weinmiller, Jürgén et al**
**Lennéstrasse 9 Postfach 24**
**D-8133 Feldafing(DE)**

(54) **Dispositif d'accord automatique de l'oscillateur commandé en tension d'une boucle à verrouillage de phase.**

(57) Synthétiseur de fréquences à large bande relative comportant une boucle à verrouillage de phase (1) équipée d'un VCO (2) à double accès (3 et 4).

La commande forte-pente (4) reçoit une tension de prépositionnement (Vp) qui est fournie par une boucle d'asservissement en tension (17 à 21). Cette boucle reçoit la tension d'asservissement (Va) de la boucle à verrouillage de phase (1) et une tension de référence (V1) qui est choisie égale à la tension d'asservissement (Va) qui donne une bonne pureté spectrale pour le VCO (2).

Fig.1

EP 0 395 109 A1

## DISPOSITIF D'ACCORD AUTOMATIQUE DE L'OSCILLATEUR COMMANDE EN TENSION D'UNE BOUCLE A VERROUILLAGE DE PHASE

La présente invention se rapporte à un dispositif d'accord automatique de l'oscillateur commandé en tension équipant une boucle à verrouillage de phase, en particulier pour synthétiseur de fréquences à large bande.

D'une manière classique, un synthétiseur de fréquences utilise une boucle à verrouillage de phase comportant un oscillateur commandé en tension, plus communément appelé "VCO" (en anglais : "Voltage Controlled Oscillator").

En particulier dans le cas des synthétiseurs à large bande d'accord relative, il est avantageux d'équiper la boucle à verrouillage de phase d'un VCO double-pente, possédant deux accès de tension de commande distincts :
. un accés de commande à forte-pente, ou accés de réglage "gros" ("coarse tune") ;
. un accés de commande à faible-pente, ou accés de réglage "fin" ("fine tune").

Les documents US-A-4.736.169 et US-A-4.684.904 décrivent par exemple des VCO de ce type.

De manière classique, au moins une partie du signal de sortie du VCO est appliquée, à travers un diviseur à rang variable dont le rang de division (ou, autrement dit, le nombre diviseur) détermine la fréquence de sortie du synthétiseur, à une première entrée de comparateur de phases qui reçoit sur son autre entrée une fréquence de référence. La tension d'erreur en sortie de ce comparateur de phases est appliquée, généralement à travers un amplificateur de mise à niveau et un filtre passe-bas, sur l'accés de commande faible-pente du VCO. Cette dernière tension sera ci-après dénommée : "tension d'asservissement".

Afin d'allier une bonne pureté spectrale et une bande d'accord relative importante, il est connu d'appliquer, sur l'accès de commande forte-pente du VCO, une tension dite "de prépositionnement". Cette tension de prépositionnement a pour rôle d'effectuer un réglage "gros" de la fréquence de sortie du synthétiseur. Sa valeur est traditionnellement réglée soit manuellement par l'intermédiaire d'un réglage potentiométrique, fonction de la fréquence de sortie désirée et accessible en face avant du synthétiseur, soit par un dispositif numérique à mémoire de type "PROM" et convertisseur numérique-analogique, qui délivre la tension de prépositionnement adéquate en fonction de la fréquence déterminée par l'organe de codage qui agit sur le diviseur à rang variable équipant la boucle à verrouillage de phase du synthétiseur.

Ces dispositifs connus ont pour inconvénients soit de ne pas être automatiques dans le cas des dispositifs à réglage manuel, soit d être onéreux, encombrants, et limités en précision par le poids du bit dans le cas des dispositifs numériques du type précité.

Un autre dispositif connu, mais lui aussi onéreux et très encombrant, est décrit dans le document FR-A-2 444 368 de la demanderesse. Il s'agit dans ce document d'un synthétiseur hyperfréquence qui utilise un résonateur constitué d'une cavité muni d'un plongeur diélectrique de longueur de pénétration réglable. Ce plongeur est couplé à un moteur électrique qui fonctionne par paliers (ce qui est un autre inconvénients et dont le sens de rotation est fonction de la tension continue appliquée à ses bornes, et il correspond au dispositif d'accord gros du résonateur. L'invention vise à remédier à ces inconvénients. Elle se rapporte en effet à un système à boucle à verrouillage de phase, notamment à un synthétiseur de fréquences à large bande, comprenant un oscillateur commandé en tension (VCO) muni d'un dispositif d'accord automatique. Cet oscillateur possède un accès de commande faible-pente qui reçoit la tension d'asservissement en provenance du comparateur de phases équipant cette boucle à verrouillage de phase, et un accès de commande forte-pente qui reçoit une tension de prépositionnement correspondant à un réglage gros de la fréquence de sortie de cette même boucle à verrouillage de phase. Cette tension de prépositionnement provient, après mise à niveau et/ou filtrage éventuels, de la tension de sortie d'un comparateur de tensions qui reçoit, sur sa première entrée de comparaison, la tension d'asservissement précitée et, sur son autre entrée, une tension de référence prédéterminée qui est préférentiellement choisie pour être égale à une tension de commande faible-pente qui donne une bonne pureté spectrale pour oscillateur.

De toute façon, l'invention sera bien comprise, et ses avantages et autres caractéristiques ressortiront, lors de la description suivante d'un exemple non limitatif de réalisation, en référence au dessin schématique annexé dans lequel :

- Figure 1 est un schéma électrique simplifié de ce synthétiseur de fréquences ; et

- Figure 2 est un diagramme de courbes qui vient aider à la compréhension du fonctionnement du dispositif de la figure 1.

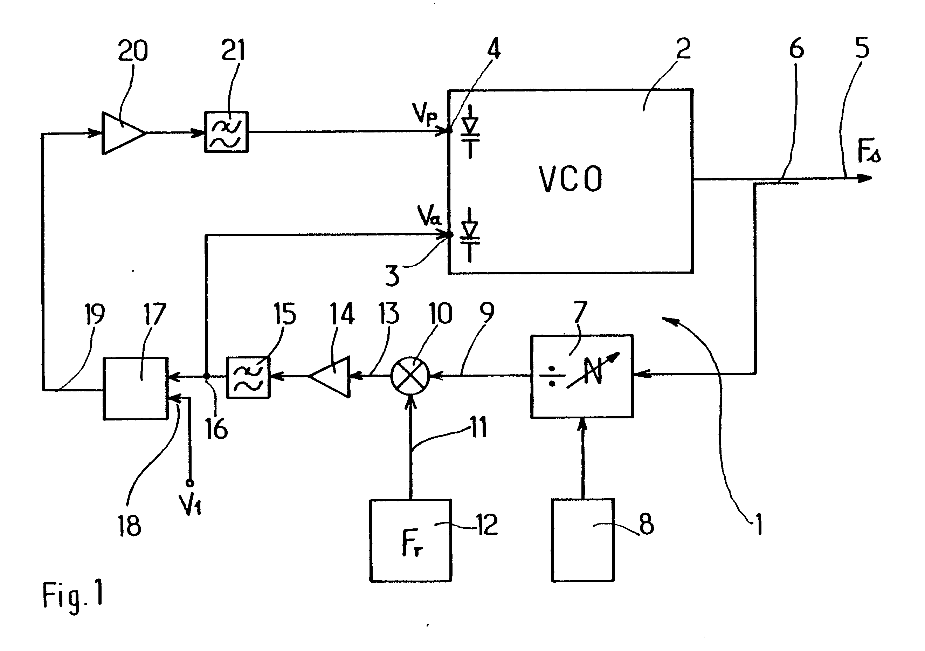

En se référant à la figure 1, ce synthétiseur de fréquences est composé d'une boucle à verrouillage de phase 1 qui est équipée d'un oscillateur commandé en tension 2, ou plus simplement VCO, qui possède deux accès de commande :

. un accès de commande faible-pente 3 qui reçoit la tension d'asservissement Va de la boucle à verrouillage de phase 1 ; et

. un accès de commande forte-pente 4 qui reçoit la tension de prépositionnement Vp. A titre d'exemple numérique, la faible-pente correspondant au varactor (simple ou multiple), associé à l'entrée 3 est de l'ordre de 100 Kilohertz par volt, tandis que la forte-pente correspondant au varactor associé à l'entrée 4 est de l'ordre de 5 à 10 Mégahertz par volt.

De manière bien classique, au moins une partie du signal de sortie en 5, à fréquence de sortie Fs, est prélevée par un coupleur 6 pour être appliquée à un diviseur à rang variable 7, dont le facteur de division (ou rang) N est déterminé par un codeur 8 de la fréquence de sortie Fs désirée. La sortie 9 du diviseur 7 est appliquée à une première entrée d'un comparateur de phases 10, qui reçoit sur son autre entrée 11 un signal de référence, dont la fréquence de référence Fr est donnée par un oscillateur à fréquence fixe 12.

Le signal d'erreur en sortie 13 du comparateur de phases 10 est appliqué sur l'entrée de commande faible-pente 3, après passage par un amplificateur de mise à niveau 14 et un filtre passe-bas 15 : ce signal sur l'entrée 3 est la tension d'asservissement Va de la boucle 1.

De manière connue en soi, la fréquence de sortie Fs est égale, lorsque la boucle 1 est verrouillée, à la fréquence de référence Fr multipliée par le facteur de division N, qui constitue donc le pas du synthétiseur.

Conformément à l'invention, la tension d'asservissement Va en sortie 16 du filtre 15 est appliquée sur une première entrée d'un comparateur de tension 17, qui reçoit sur son autre entrée 18 une tension de référence V1 et qui fournit en conséquence sur sa borne de sortie 19 une tension égale ou proportionnelle à la différence de tension Va-V1.

La tension d'erreur en 19 est appliquée à travers un amplificateur de mise à niveau 20 et un filtre passe-base 21, sur l'accès forte-pente 4 pour constituer par suite la tension de prépositionnement Vp du VCO 2.

La tension de référence V1 n'est pas quelconque : elle est égale à la tension d'asservissement Va qui est optimale d'une part pour faire fonctionner le VCO avec une bonne pureté spectrale, et correspond donc à un point de fonctionnement à particulièrement faible-pente du varactor associé à l'entrée 3, et d'autre part pour que ce même varactor fonctionne dans ses conditions optimales, ce qui est le cas si sa tension de polarisation Va est élevée.

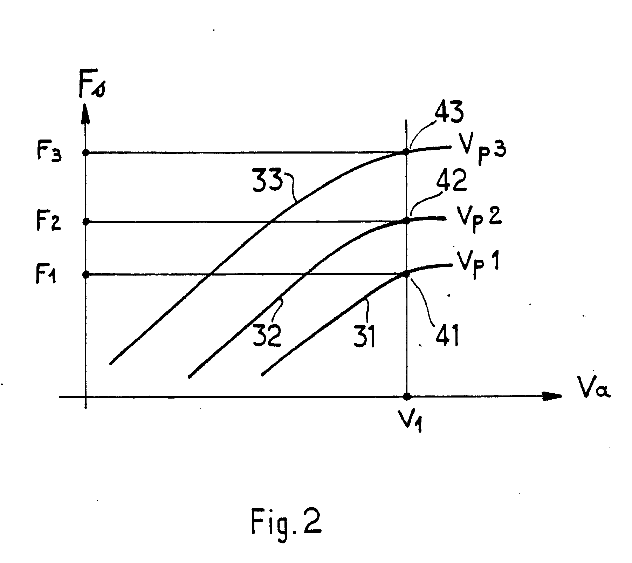

Ceci apparaît plus clairement à l'examen du réseau de courbes de la figure 2. Sur ce diagramme, les courbes 31, 32, et 33 correspondent à la variation de la fréquence de sortie Fs du synthétiseur en fonction de la tension d'asservissement Va en 3, pour des tensions de prépositionnement Vp respectivement égales à Vp1, Vp2 et Vp3.

On voit qu'en choisissant pour V1, une valeur assez élevée (par exemple une dizaine de volts pour fixer les idées), les points de fonctionnement correspondants 41, 42 et 43, qui sont relatifs respectivement à des fréquences de sortie F1, F2 et F3, sont situés chacun sur une zone à faible-pente des courbes respectives 31, 32 et 33. Comme par ailleurs, cette valeur V1 est relativement élevée, elle présente l'avantage de correspondre toujours à un point de fonctionnement pratiquement optimal du varactor associé à l'entrée 3.

Par constitution, les constantes de temps du circuit d'asservissement en tension (17, 20, 21) sont choisies très supérieures à celles du circuit d'asservissement (7, 10, 14, 15) de la boucle à verrouillage de phase 1.

D'une façon générale, ce dispositif évoluera de façon que la tension de préposition Vp en 4 prenne une valeur telle que la tension d'asservissement Va, en 16 et 3, soit égale à la tension V1, c'est à dire (figure 2) corresponde au point de fonctionnement 41 (tension de perfectionnement prenant la valeur Vp1) pour une fréquence Fs (demandée par le codeur 8) égale à F1, et pareillement (42, Vp2) pour une fréquence F2, puis (43, Vp3) pour une fréquence F3, et ainsi de suite.

L'analyse plus détaillée du fonctionnement de ce dispositif est la suivante :

A la mise sous tension, les conditions d'origine sont par exemple, et par supposition, les suivantes :

. la boucle d'asservissement en fréquences 1 est en butée haute ;

. la boucle d'asservissement (17 à 21) en tension de prépositionnement est en butée basse.

A la mise en service, la tension d'asservissement Va étant en butée haute, (donc supérieure à V1), la tension de sortie Vp du circuit de prépositionnement automatique (17 à 21) monte conformément à la constante de temps de ce circuit.

Lorsque sa valeur entre dans la zone de capture de la boucle d'asservissement 1, le verrouillage de phase peut s'effectuer. La tension de prépositionnement continue cependant à monter jusqu'à ce que la tension d'asservissement Va descende en dessous de la valeur de référence V1. A ce moment, et au temps de réponse près de la boucle de prépositionnement (17 à 21), le sens de variation s'inverse jusqu'à ce que la tension d'asservissement Va remonte à la valeur de référence V1, qu'elle dépasse alors légèrement, et ainsi de suite avec des oscillations de plus en plus amorties jusqu'à verrouillage total du dispositif, avec Va = V1. On remarque finalement qu'avec ce dispositif, le VCO travaille toujours à l'optimum de ses performances, les réglages étant optimisés à une seule et même valeur de tension d'asservissement Va = V1. Les composants à ajouter pour la réalisation de la boucle de prépositionnement automatique (17 à 21) sont peu nombreux, de faible coût, et de moindre encombrement. En outre, les variations de fréquence dûes aux variations de température sont automatiquement rattrapées, du fait que, grâce à ce dispositif, la tension d'asservissement Va reste toujours égale à la tension de référence V1, même si le VCO lui-même tend à bouger avec les écarts de température.

Comme il va de soi, l'invention n'est pas limitée à l'exemple de réalisation qui vient d'être décrit, mais est bien au contraire susceptible d'être mise en oeuvre selon de nombreuses formes équivalentes.

## Revendications

1/ Système à boucle à verrouillage de phase, notamment synthétiseur de fréquences à large bande, caractérisé en ce qu'il comprend un oscillateur VCO (2) muni d'un dispositif d'accord automatique (12) équipant la boucle à verrouillage de phase (1).

2/ Système selon la revendication 1, caractérisé en ce que cet oscillateur (2) possède un accès de commande faible-pente (3) qui reçoit une tension d'asservissement (Va) en provenance du comparateur de phases (10) équipant la boucle à verrouillage de phase (1), et un accès de commande forte-pente (4) qui reçoit une tension de prépositionnement (Vp) correspondant à un réglage gros de la fréquence de sortie (Fs) de cette même boucle à verrouillage de phase (1), et en ce que cette tension de prépositionnement (Vp) provient, après passage éventuel à travers un amplificateur (20) de mise à niveau et/ou un filtre passe-bas (21), d'un comparateur de tensions (17) qui reçoit, sur sa première entrée de comparaison (16), la tension d'asservissement précitée (Va) et, sur son autre entrée (18), une tension de référence prédéterminée (V1).

3/ Système selon la revendication 2, caractérisé en ce que cette tension de référence (V1) est choisie pour être égale à une tension de commande faible-pente (Va) qui donne une pureté spectrale optimale pour cet oscillateur (2).

4/ Système selon la revendication 3, caractérisé en ce que cette tension de référence (V1) est choisie d'une valeur assez élevée, correspondant à un fonctionnement optimal du ou des varactors associés à cet accès de commande faible-pente (3).

5/ Système selon la revendication 4, caractérisé en ce que cette tension de référence (V1) est de l'ordre d'une dizaine de volts.

6/ Système selon l'une des revendications 2 à 5, caractérisé en ce que les constantes de temps du circuit de prépositionnement (17 à 21) sont choisies très supérieures à celles du circuit d'asservissement (7, 10, 14, 15) de la boucle à verrouillage de phase (1).

Fig.1

Fig. 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 280 104 (RZESZEWSKI) <br> * Figure 1; colonne 3, ligne 61 – colonne 6, ligne 19 * <br> --- | 1 | H 03 L  7/187 |
| X | GB-A-1 390 232 (COMMUNICATION ASSOCIATES) <br> * Figures 1,5; page 2, ligne 89 – page 3, ligne 2; page 7, ligne 73 – page 8, ligne 88 * <br> --- | 1,5 | |
| A,D | US-A-4 684 904 (WATKINS et al.) <br> * Figure 1; résumé * <br> --- | 1 | |
| A,D | US-A-4 736 169 (WEAVER et al.) <br> * Figure 1; résumé * <br> --- | 1 | |
| A | US-A-4 310 809 (BUCK et al.) <br> * Figure 1; résumé * <br> ----- | 1 | |

DOMAINES TECHNIQUES
RECHERCHES (Int. Cl.5)

H 03 B
H 03 L

Le présent rapport a été établi pour toutes les revendications

| Lieu de la recherche | Date d'achèvement de la recherche | Examinateur |
|---|---|---|
| LA HAYE | 12-07-1990 | PEETERS M.M.G. |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
..............................................................................
& : membre de la même famille, document correspondant

EPO FORM 1503 03.82 (P0402)